## Europäisches Patentamt

## European Patent Office

## Office européen des brevets

(11) Publication number: **0 249 755 B1**

# EUROPEAN PATENT SPECIFICATION

(45) Date of publication of patent specification: **28.11.90**

(51) Int. Cl.⁵: **H 01 L 25/16**

(21) Application number: **87107168.4**

(22) Date of filing: **18.05.87**

(54) Hybrid integrated circuit apparatus.

(30) Priority: **19.05.86 JP 114415/86**

(43) Date of publication of application:
**23.12.87 Bulletin 87/52**

(45) Publication of the grant of the patent:
**28.11.90 Bulletin 90/48**

(84) Designated Contracting States:
**DE FR GB IT**

(56) References cited:
**GB-A-2 125 618**
**US-A-4 521 449**

(73) Proprietor: **NIPPONDENSO CO., LTD.**
**1-1, Showa-cho**
**Kariya-shi Aichi-ken (JP)**

(72) Inventor: **Nagasaka, Takashi**
**9-22, Minami-machi**
**Anjo-shi Aichi-ken (JP)**

(74) Representative: **Kuhnen, Wacker & Partnei**
**Schneggstrasse 3-5 Postfach 1553**
**D-8050 Freising (DE)**

EP 0 249 755 B1

Courier Press, Leamington Spa, England.

Description

The present invention relates to a hybrid integrated circuit in which circuit elements such as a thick film resistor are formed on a substrate constitued by sintering, e.g., an alumina green sheet and, more particularly, to a hybrid integrated circuit in which a terminal conductor is formed on a substrate surface so as to connect, e.g., a thick film resistor.

A substrate constituting a hybrid integrated circuit is constituted by printing a refractory conductor material such as tungsten (W) and molybdenum (Mo) to form a wiring conductor and baking the resultant substrate on which the conductor material is printed in a reducing atmosphere at a temperature of about 1,600°C. Then, circuit elements such as a thick film resistor and a flip chip are formed on the baked alumina substrate.

Conventionally, in order to form, e.g., a thick film resistor on an alumina substrate, a silver-based conductor such as an Ag, Ag—Pt, or Ag—Pd conductor is formed as a terminal conductor on a printed conductor material constituting a wiring conductor, and then a thick film resistor layer is so formed as to be electrically connected to the terminal conductor.

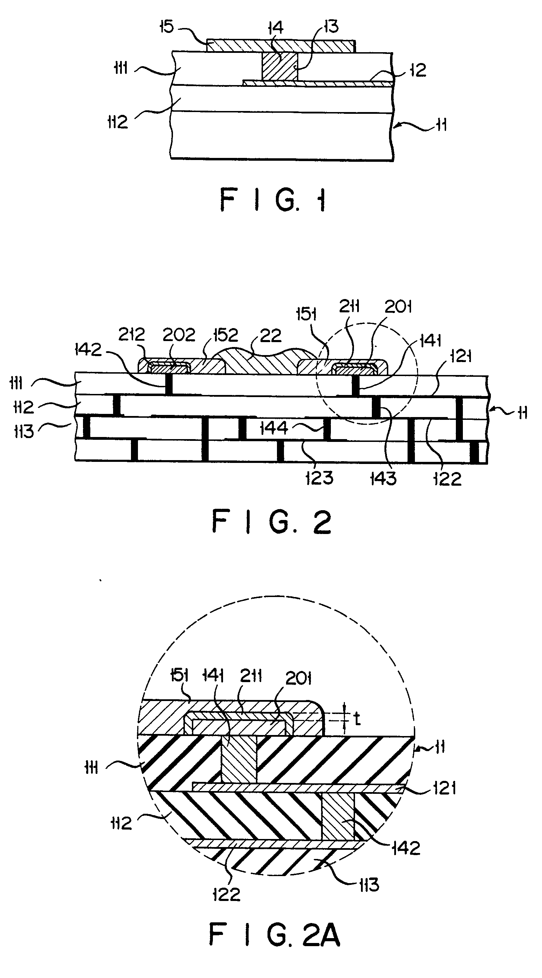

The above substrate is sometimes constituted by a multilayer substrate obtained by laminating a plurality of substrates, and forming wiring layers made of the above-mentioned refractory conductor material therebetween. In such a multilayer substrate, conductor materials serving as conductor wirings formed inside the substrate are electrically connected to flip chips and the like in a manner as shown in Figure 1.

In Figure 1, multilayer substrate 11 is constituted by laminating a plurality of substrates 111, 112, ..., and wiring conductor layer 12 is formed therebetween as needed. In order to electrically connect layer 12 to the surface of substrate 11, through-hole 13 is formed in uppermost substrate 111, and conductor 14 is filled by nickel plating, gold plating, or the like, in hole 13 so that the surface of conductor 14 is substantially flattened to obtain the same surface level as that of substrate 11. For example, thick film conductor 15 is formed on the surface of substrate 11 by printing, and layer 12 and conductor 15 are electrically connected with each other by conductor 14. Conductor 15 serves as a terminal conductor, and, e.g., a flip chip is placed on conductor 15 by soldering (Pb—Sn), so that the flip chip and layer 12 are electrically connected with each other. In addition, a thick film resistor (not shown) is formed on substrate 11 as needed so as to partially overlap the above thick film conductor.

In order to form the thick film resistor on substrate 11, conductor 15, serving as a terminal conductor and a resistor material layer for forming the thick film resistor, are baked in air at about 850°C. Therefore, an antioxidant action with respect to a conductor material is required for this baking. For example, an Au film is formed on the surface of the conductor material to prevent oxidation thereof, which results in high cost due to use of Au.

Furthermore, in the case of mounting a flip chip and the like on substrate 11, hole 13, formed in uppermost substrate 111 of substrate 11 is filled with a conductor, to flatten a portion of the surface of substrate 11 corresponding to hole 13, so that conductor 15 is formed so as to be a flat surface, in order to prevent disconnections and the like. In the case of forming the flip chip by soldering on the surface of the conductor material constituting conductor 15, Ni- and Au-plated layers are formed between the solder and the conductor material. However, since Ni has a relatively large ionization tendency, the surface of the conductor material must be activated by a catalyst when it is plated.

It is therefore an object of the present invention to provide a hybrid integrated circuit in which antioxidation of a conductor material which constitutes a thick film conductor serving as a terminal conductor, to be formed on a multilayer substrate, can be performed without the need to use an expensive material such as Au, so that a thick film resistor or a solder on which a flip chip is mounted can be so formed as to be connected to the thick film conductor, thereby effectively connecting the resistor, the solder, and the like to the terminal conductor.

It is another object of the present invention to provide a highly reliable hybrid integrated circuit, in which a contact resistance can be decreased enough especially in a bonding portion between the terminal conductor and the thick film conductor or the flip chip, and strength of the bonding portion can be sufficiently improved.

It is still another object of the present invention to provide a hybrid integrated circuit, in which the surface of the terminal conductor can be prevented from oxidation by making use of a metal material with a relatively small ionization tendency, so that in the case of forming the thick film resistor or the solder for mounting the flip chip thereon, the surface of the conductor material constituting the terminal conductor need not be activated, thereby simplifying the manufacturing steps.

These objects are met by the features of the invention as claimed.

More specifically, in the hybrid integrated circuit according to the present invention, a thick film conductor serving as a terminal conductor by a conductive material is printed on the surface of a multilayer substrate constituted by sintering, and this conductor material constituting the thick film conductor is constituted by a conductor material having a melting point higher than the sintering temperature of the multilayer substrate. In addition, a layer of plated copper is formed on at least a portion of the conductive material or is formed to cover the conductive material portion to be exposed on the substrate surface. Furthermore, the thick film conductor is baked in a nitrogen atmosphere so that at least a portion thereof is formed on the plated layer portion.

That is, in the hybrid integrated circuit having the above arrangement, antioxidation of the conductor material constituting the terminal conductor is effectively performed on the layer of plated copper, and the copper forming the plated layer is easily precipitated because it has a relatively low ionization tendency, so that the surface of the conductor material need not be activated by a catalyst. In addition, since the thick film conductor layer formed on the substrate is baked in the nitrogen atmosphere, oxidation of the conductor material can be more reliably prevented, thereby effectively improving reliability of the hybrid integrated circuit apparatus.

This invention can be more fully understood from the following detailed description when taken in conjunction with the accompanying drawings, in which:

Figure 1 is a sectional view explaining a conventional hybrid integrated circuit;

Figure 2 is a sectional view of a multilayer substrate portion of a hybrid integrated circuit according to an embodiment of the present invention;

Figure 2A is an enlarged sectional view of a part of the multilayer substrate shown in Figure 2;

Figure 3 is a graph of a relationship between a contact resistance and a heat cycle in a terminal conductor portion of the hybrid integrated circuit apparatus;

Figure 4 is a graph of bonding strength deteriorations over a period of time;

Figure 5A is a schematic view of a sectional structure in which a thick film conductor layer of copper is directly formed on a conductor material;

Figure 5B is a schematic sectional view of a resultant structure obtained when the structure shown in Figure 5A is baked;

Figure 6A is a schematic sectional view of a structure in which a layer of plated copper is formed on the conductor material;

Figure 6B is a schematic sectional view of a resultant structure obtained when the structure shown in Figure 6A is baked;

Figure 7 is a sectional view for explaining an arrangement of a multilayer substrate of a hybrid integrated circuit according to a second embodiment of the present invention;

Figure 8 is a graph of a relationship between a film thickness and bonding strength of the copper-plated layer;

Figure 9 is a graph illustrating a relationship between a film thickness and solder wettability of the copper-plated layer;

Figure 10 is a graph illustrating a relationship between a film thickness and an expansion coefficient of the copper-plated layer;

Figure 11 is a sectional view for explaining a third embodiment of the present invention; and

Figures 12A and 12B are views respectively showing arrangements of the copper-plated layers and conductor patterns on the multilayer substrates.

Multilayer substrate 11 shown in Figure 2 is constituted by laminating a plurality of sheet substrates 111, 112, . . ., each of which is a ceramic green sheet containing 90 to 95% of an alumina ceramic. Conductive layers 121, 122, . . . respectively, made of a refractory metal material such as Mo (a melting point of 2,622°C) or W (a melting point of 3,382°C), are printed on the ceramic green sheets constituting substrates 111, 112, . . ., and a plurality of the ceramic green sheets on which layers 121, 122, . . . are formed and laminated by a conventionally known layer laminating methods or a printing method to constitute substrate 11.

In the case of adopting the layer laminating method, layers 121, 122, . . . are respectively printed beforehand on a plurality of ceramic green sheets to be laminated. Thereafter, the sheets are laminated by via-fill insertion or the like and then baked in a reducing atmosphere at about 1,600°C, thereby constituting one multilayer substrate 11. In this case, through holes are so formed to connect substrates 111, 112, . . . with layers 121, 122, . . ., respectively, and as partially shown in Figure 2a, the respective through holes are filled with conductors 141, 142, . . .. In addition, conductive material layers 201 and 202 are formed on the surface of uppermost substrate 111 so as to correspond to conductors 141 and 142 is filled into through holes.

Layers of plated copper (Cu) 211 and 212 are formed on the surface of substrate 11 so as to cover the exposed surfaces of conductive material layers 201 and 202, respectively. Layers 211 and 212 may be formed by electroless plating such as chemical copper plating.

After layers 211 and 212 of plated copper are thus formed, thick film conductive layers 151 and 152 serving as terminal conductors are so formed as to cover copper-plated layers 211 and 212, respectively, and thick film resistor layer 22 is so formed as to connect conductive layers 151 and 152. Layers 151 and 152 are formed by, e.g., copper printing. Then, layers 151 and 152 and resistor layer 22 are baked in a nitrogen atmosphere.

In this case, sintering is required to assure contact between copper-plated layers 211 and 212 and conductive material layers 201 and 202. However, in this embodiment, layers 211 and 212 of plated copper are simultaneously heated during the baking of resistor layer 22 and conductive layers 151 and 152 and are therefore in the same state as that of sintering.

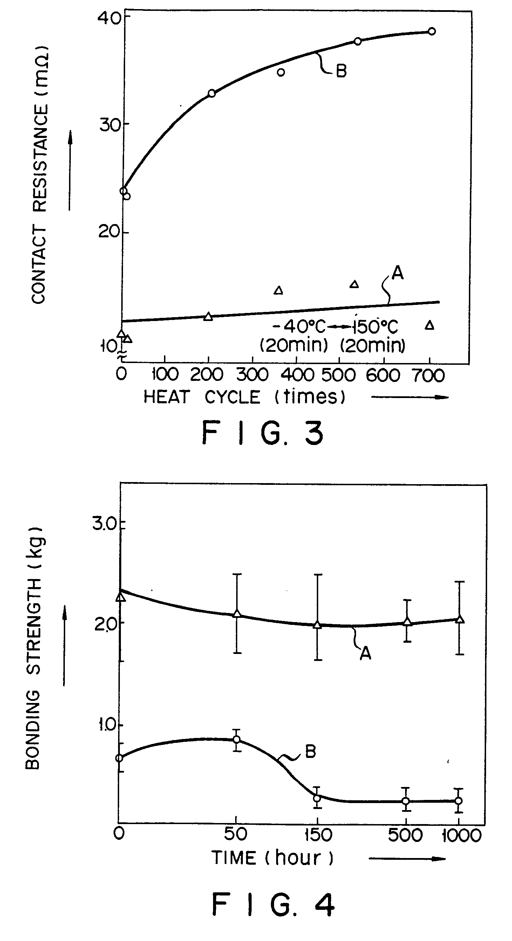

When the terminal conductor is formed on the surface of substrate 11 as described above, oxidation of conductive material layers 201 and 202 can be reliably prevented, because conductive layers 151 and 152 and resistor layer 22 are baked in the nitrogen atmosphere. Layers 211 and 212 of plated copper serve as bonding interlayers used for electrically connecting conductive material layers 201 and 202 with resistor layer 22. Contact resistances of layers 211 and 212 are relatively small as represented by property A in Figure 3. In addition, the bonding strength of portions corresponding to layers 211 and 212 is increased as represented by property A in Figure 4, and this bonding strength will remain at a high level even after an extended period of time.

Note that values shown in Figure 3 were obtained as a result of one heat cycle of −40°C for 20 min and 150°C for 20 min, and that properties B in Figures 3 and 4 are obtained when the copper-plated layer is not formed, i.e., layers 151 and 152 are directly formed on conductors 141 and 142.

As described above, by interposing layers 211 and 212 of plated copper between conductive material layers 201, 202 and conductive layers 151, 152, the contact resistance is decreased and the bonding strength of the bonded portion is improved due to the following reason.

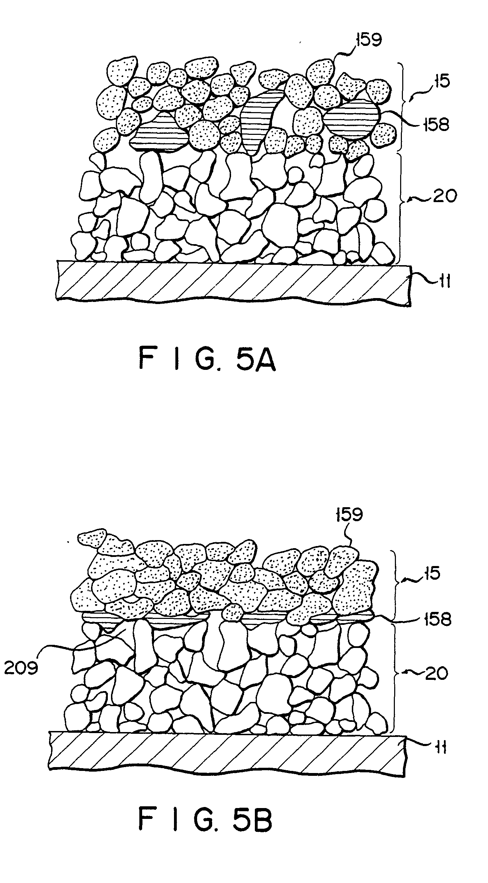

Figure 5A shows the case in which thick film conductive layer 15 is directly laminated on conductive material layer 20 without forming a copper layer. Although material of layer 20 is normally porous, the size of copper particles 159, constituting layer 15 is about 0.1 to 5 μm, and hence particles 159 cannot enter into material of layer 20. In addition, glass 158 such as a Bi, B, or Si glass is contained in the components of layer 15 so as to produce a high strength of adhesion with substrate 11 and reach the interface between conductive material layer 20 and conductive layer 15 as shown in Figure 5B, during baking of layer 15 by copper, so that adhesion between conductive material layer 20 and conductive layer 15 is avoided.

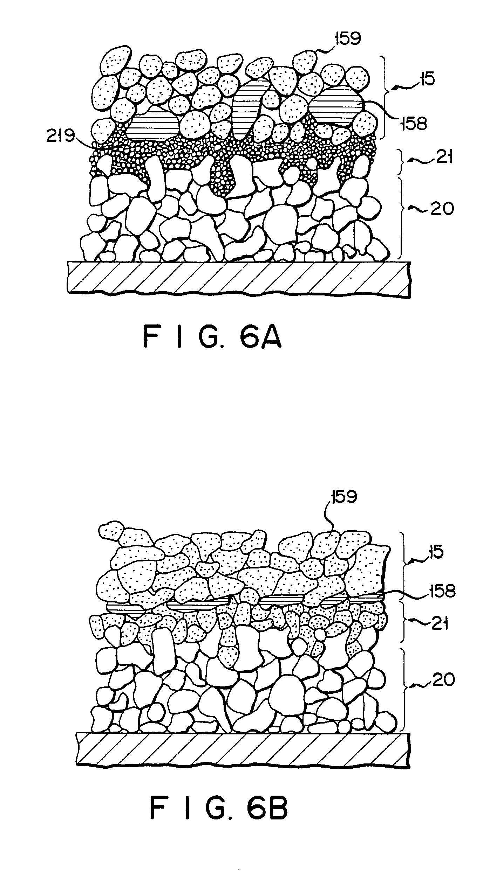

Figure 6A shows the state in which copper-plated layer 21 is formed between conductive material layer 20 and conductive layer 15. Copper (Cu) ions contained in layer 21 have a relatively high reducing power and hence can be easily precipitated, and during plating, ions are relatively small particles 219 with a size of 0.1 to 0.2 μm and hence can enter deeply into porous conductive material layer 20. Therefore, after baking of conductive layer 15, copper-plated layer 21 is intertwined and bonded on the bonding surface portion, thereby increasing the bonding strength. Furthermore, a glass layer is not formed between layer 21 and layer 20, thereby decreasing the contact resistance in this portion.

According to a destructive test performed by the present inventor, peeling occurs between copper-plated layer 21 and conductive material layer 20. Therefore, it is supposed that a primary factor of a decrease in bonding strength in this portion is not glass 158 formed between copper-plated layer 21 and conductive layer 15, but gaps 209 shown in Figure 5B.

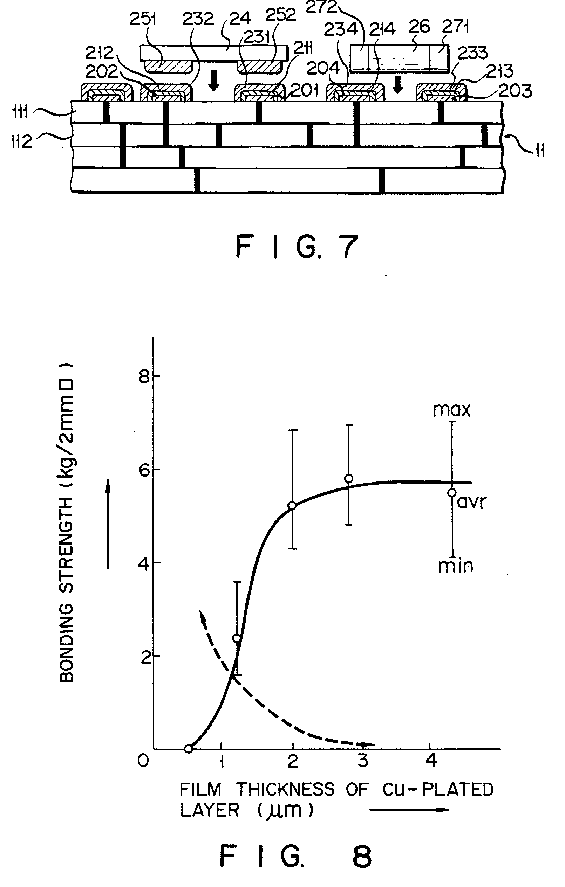

Figure 7 shows a second embodiment of the present invention, in which a flip chip is formed. In Figure 7, the same parts as in Figure 2 are denoted by the same reference numerals, and a detailed description thereof will be omitted.

That is, in the second embodiment, copper-plated layers 211 and 212 are so formed as to cover conductive material layers 201 and 202, respectively, and solder layers 231 and 232 are so formed as to cover layers 211 and 212, respectively. Layers 231 and 232 are respectively adhered to electrodes 251 and 252 of flip chip 24, so that chip 24 is connected to multilayer substrate 11.

In addition, in the second embodiment, conductive material layers 203 and 204 are formed, layers of plated copper 213 and 214 are respectively formed on conductive material layers 203 and 204, and solder layers 233 and 234 are respectively formed on layers 213 and 214. Furthermore, electrodes 271 and 272 of the discrete element 26, e.g., a capacitor, is adhered to layers 233 and 234, repectively, so that element 26 is connected to substrate 11.

With the above arrangement, similar to the case of the first embodiment, the contact resistance is decreased and the bonding strength is improved in conductive material layers 201 to 204, and the following effects can be additionally obtained.

That is, when solder layers 231 to 234 are melted to mount chip 24 and element 26, a temperature thereof becomes about 250°C. For this reason, it is supposed that conductive material layers 201 to 204 are oxidized to some extent. However, since layers 201 to 204 are coated with layers of plated copper 211 to 214, respectively, oxidation of layers 201 to 204 are effectively prevented.

In addition, when layers of plated copper 211 to 214 are formed, copper as a material thereof can be easily precipitated because of its relatively small ionization tendency. For this reason, the surface of the conductive material need not be activated by, e.g., a catalyst, thereby effectively simplifying the manufacturing steps. Furthermore, if an Ni-plated layer is formed on the surface of the conductive material as is conventionally known and is oxidized, it is difficult to remove this oxide because a strong acid must be used. However, a copper oxide can be easily removed.

In a conventional multilayer substrate, conductors are filled by, e.g., Ni plating or Au plating into the through holes formed in the uppermost sheet substrate, so that the conductors are electrically connected to a thick film conductor formed on the surface of the substrate.

However, in substrate 11 constituting the hybrid integrated circuit according to the present invention, conductive material layers 201 and 202 are formed on the surface of substrate 11 by exposing conductors in the through holes to the surface of substrate 11. Therefore, no step is formed between the surfaces of the through hole portions and substrate 11, and the area of conductive material layers 201, 202, ... exposed on the surface of substrate 11 can be increased, thereby easily improving the bonding strength of the layers of plated copper 211, 212, ....

In addition, when the through holes are plated with Ni, to form conductors, a Ni-plated layer must be formed to a thickness corresponding to that of the sheet substrate in the portions of the through holes, and it is difficult to assure such a thickness by means of electroless plating. On the other hand, when electrolytic plating is performed, electrical wiring must be formed in the substrate.

On the contrary, layers of plated copper 211, 212, ... shown in the second embodiment need not have such a thickness, so that substantially no problem is posed with the relatively thin plated layers.

Note that in a conventional apparatus, a diameter of the through holes may be increased to increase the bonding strength between the conductive material layers and the plated layers formed in the through holes. However, with this arrangement, a difference between the thermal expansion coefficients of the plated metal and the substrate cannot be neglected.

In both the first embodiment and the second embodiment the strength of the bonding between the conductive material layers can be increased by adjusting the thickness of copper-plated layers 211, 212, . . ..

Figure 8 shows results obtained by testing the state of bonding strength corresponding to a thickness of the copper-plated layer, in which the bonding strength between the copper-plated layer and a thick film conductor constituted by tungsten were measured. As is apparent from the test result represented by a solid line, it is confirmed that the bonding strength is increased when the thickness of the layer of plated copper is about 2 μm or more.

In addition, the property represented by a broken line in Figure 8 shows generation of black dots, caused by the tungsten which is exposed on a part of the surface of the layer of plated copper. When the thickness of the layer of plated copper is about 2 μm or less, the dots are increasingly generated, thereby degrading solder wettability on the copper layer since the solder does not attach to tungsten.

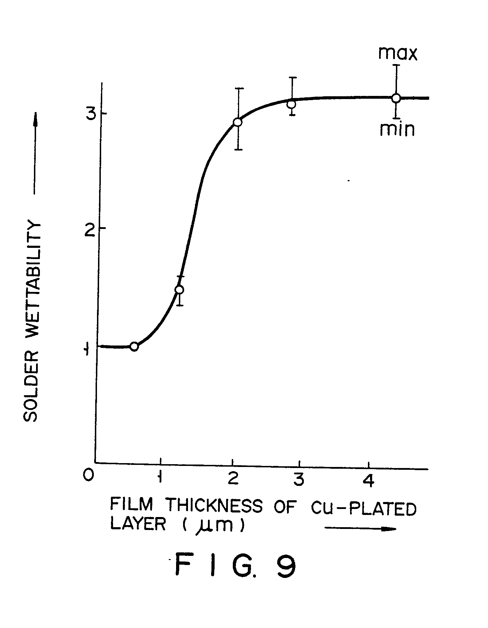

Figure 9 shows a relationship between the thickness and solder wettability of the layer of plated copper. When the thickness of the copper layer exceeds 2 μm, good solder wettability can be obtained.

Assuming that a diameter of the solder before heating is r1 and that after heating is r2, solder wettability R is represented by "$R = r2/r1$".

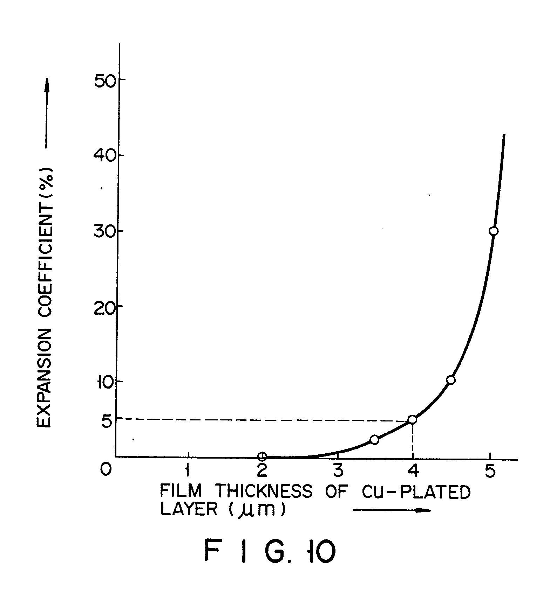

Figure 10 shows a result obtained by testing the expansion coefficient of the layer of plated copper, in which the abscissa represents the film thickness of the copper layer and the ordinate represents the expansion coefficient (%) as a ratio of areas of a portion where the copper layer is well-formed and an expanded portion.

In this test, tungsten is used as conductive material layer 20 having a size of "2.1×0.65 mm", and the layer of plated copper is formed on layer 20. In this case, if the expansion coefficient is 5% or less, practically no problem is posed. Therefore, it is confirmed from the test result that when the film thickness of the copper layer is about 4 μm or less, a satisfactory result can be obtained.

As is apparent from the test results shown in Figures 8 to 10, it is found that the film thickness of layer of plated copper 21 formed on conductive material layer 20, i.e., a film thickness represented by $t$ in Figure 2a is desirably set within the range of about 2 to 4 μm. Note that in Figures 8 and 9, each of the plots represented by circles indicate an average value of results measured several times under the same conditions, and simultaneously indicates the ranges of maximum (max) and minimum (min) values corresponding to each plot during measurement.

Note that in the second embodiment, substrate 11 is shown as a multilayer structure. However, if substrate 11 is constituted by a single substrate, the present invention can be applied without modifications. In addition, as a terminal conductor, connected to a wiring conductor and formed on substrate 11, a structure in which the layer of plated copper is formed on the surface of the conductive material can be adopted without modifications.

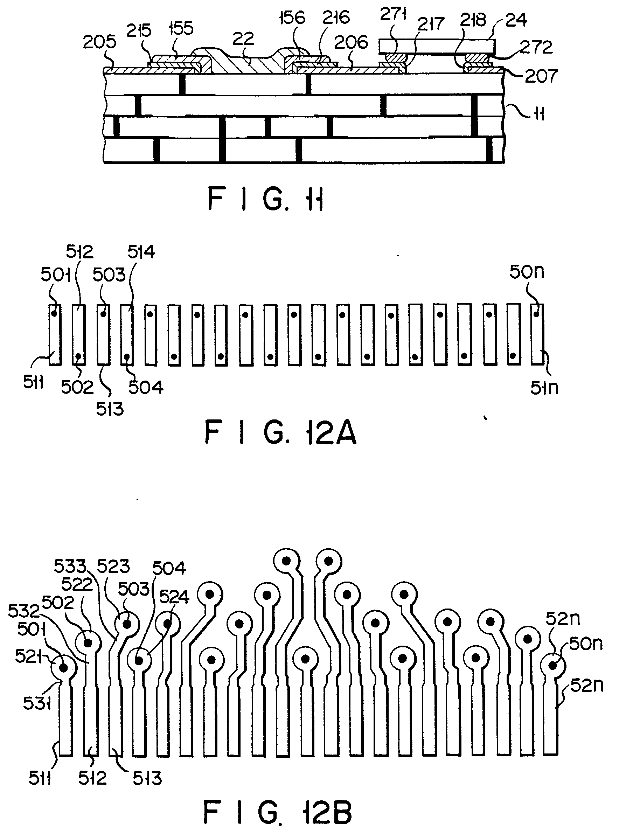

Figure 11 shows a third embodiment of the present invention, in which as wiring means for forming a circuit on the surface of multilayer substrate 11 constituted in the same manner as in the first and second embodiments, conductive material layers 205, 206, and 207 are formed on multilayer substrate. Layers of plated copper 215 to 218 are so formed as to cover portions of layers 205 to 207, respectively. In addition, thick film conductive layers 155 and 156 are respectively formed on copper layers 215 and 216. Thick film resistor layer 22 is so formed as to connect conductive layers 155 and 156. Furthermore, solder layers 271 and 272 are formed on copper-plated layers 217 and 218, so that flip chip 24 is mounted on layers 217 and 218.

That is, the layers of plated copper need not be so formed as to cover the entire surface of the conductive material layers, but need only be formed on the thick film layers required to connect circuit elements or on a portion necessary for forming the solder layers required to mount a flip chip.

In the case wherein the portions of the conductive material layers are not covered with the copper layers and the like but exposed, if the exposed surfaces are coated with, e.g., epoxy resin, oxidation can be effectively prevented. In addition, when solder is melted in a reducing gas (e.g., nitrogen) atmosphere, antioxidation can be satisfactorily achieved.

Figure 12A shows a circuit pattern formed on a multilayer substrate. When layers of plated copper 501, 502, ... respectively, are formed on a plurality of conductive material layers, serving as terminal conductors, they are to be arranged at equal intervals, solder layers 511, 512, ... are formed parallel to each other from the respective positions of layers 501, 502, ... so as to form elongated rectangular patterns. In addition, for example, bumps of a flip chip are connected to the solder layers in the rectangular patterns.

Furthermore, as shown in Figure 12B, when copper-plated layers 501, 502, ... are arranged at relatively large intervals, conductive layers 521, 522, ... are formed in relatively large areas in correspondence to portions of layers 501, 502, ..., respectively, so that conductive layers 521, 522, ... are connected to portions of solder layers 511, 512, ..., formed parallel to each other in elongated rectangular patterns, respectively through conductive layers 531, 532, .... In addition, for example, bumps of flip chip are connected to portions of solder layers 511, 512, ... in the rectangular patterns.

Figure 12B shows that patterns of conductive layers 521, 522, ... can be formed in relatively large areas on portions where layers of plated copper 501, 502, ... are formed. Therefore, deviation may be produced in positions where the solder layers are formed, because of a difference between the extents of sintering of the multilayer substrate, and the conductive material layers, resulting in difficult alignment between the flip chip and the bump. However, as shown in Figure 12B, if relatively large conductive layers 521, 522, ... are formed in portions where the layers of plated copper are to be formed, the above deviation produced during sintering can be absorbed. Furthermore, in the pattern shown in Figure 12B, since solder layers 511, 512, ... are formed separate from copper-plated layers 501, 502, ..., layers 501, 502, ... are not directly subjected to thermal and mechanical influences when bumps are mounted on solder layers 511, 512, ..., thereby effectively improving reliability of the hybrid integrated circuit apparatus.

## Claims

1. A hybrid integrated circuit comprising a sintered multilayer substrate (11) with conductive layers (121, 122, ...) provided on surfaces of substrate layers (112, 113, ...) of said substrate (11) in such a way that each conductive layer (121, 122, ...) is interposed between two substrate layers (111, 112, 113, ...), said conductive layers (121, 122, ...) being interconnected via throughholes filled with conductors (141, 142, ...), characterized in that said conductors (141, 142, ...) in said throughholes of a first substrate layer (111) are each covered with a layer (211, 212, ...) of plated copper on which a conductor layer (151, 152, ...) is formed.

2. A hybrid integrated circuit according to claim 1, characterized in that a conductive material layer (201, 202, ...) is provided between said conductors (141, 142, ...) and said layer of plated copper (211, 212, ...).

3. A hybrid integrated circuit according to claim 2, characterized in that said conductive material layer (201, 202, ...) is porous.

4. A hybrid integrated circuit according to one of claims 2 or 3, characterized in that said conductive material layer (201, 202, ...) is prepared by sintering.

5. A hybrid integrated circuit according to claim 1, characterized in that a circuit portion (22, 24, 26) is formed on said substrate (11) and said conductor layer (151, 152, ...) is used as connecting terminals.

6. A hybrid integrated circuit according to claim 1, characterized in that said substrate (11) consists of a lamination of a plurality of sheet substrates (111, 112, ...).

7. A hybrid integrated circuit according to claim 1, characterized in that said substrate (11) is a laminate of a plurality of ceramic green sheets which contain an alumina ceramic as the major constituent, said ceramic green sheets being formed such that conductive layers (121, 122, ...) constituted by the conductive material having the melting point higher than the sintering temperature of said substrate (11) are respectively formed on surfaces thereof.

8. A hybrid integrated circuit according to one of claims 2 to 7, characterized in that said substrate (11) is constituted by a single multilayer substrate obtained by laminating and sintering a plurality of sheet substrates (111, 112, ...) which contain an alumina ceramic as its major constituent, said sheet substrate being formed such that conductive layers (121, 122, ...) constituted by the conductive material having the melting point higher than the sintering temperature of said substrate are respectively formed on surfaces thereof, said conductive layers being exposed on the surface of said multilayer substrate so that conductive material layers (201, 202, ...) are formed on said substrate surface.

9. A hybrid integrated circuit according to one of claims 2 to 8, characterized in that said layers (211, 212, ...) of plated copper are so formed as to cover the entire conductive material layers (201, 202, ...).

10. A hybrid integrated circuit according to one of claims 2 to 9, characterized in that said layers (216, 217, ...) of plated copper are so formed as to cover portions of said conductive material layers (205, 206, ...).

11. A hybrid integrated circuit according to claim 1, characterized in that said copper-plated layers (211, 212, ...) are formed so that a film thickness thereof falls within a range of 2 to 4 µm.

12. A hybrid integrated circuit according to claim 1, characterized in that said conductor layers (151, 152, ...) are constituted by thick film conductor layers formed on at least portions of said copper-plated layers (211, 212, ...), said thick film conductor layers forming patterns extending to positions where circuit elements are connected.

13. A hybrid integrated circuit according to claim 1, characterized in that said conductor layers (151, 152, ...) are constituted by thick film conductor layers printed on at least portions of said layers (211, 212, ...) of plated copper and baked in a nitrogen atmosphere.

14. A hybrid integrated circuit according to claim 1, characterized in that said conductor layers are constituted by solder layers (233, 234) connected to circuit elements (24, 26).

15. A multilayer structure for a hybrid integrated circuit comprising a plurality of substrate layers (111, 112, ...) with throughholes therein, filled with conductors (141, 142, ...) and conductive layers (121, 122, ...) formed between said substrate layers (111, 112, ...), said conductive layers being interconnected via said throughholes, characterized in that said conductors (141, 142, ...) in said throughholes of a first substrate layer (111) are each covered with a layer (211, 212, ...) of plated copper.

## Patentansprüche

1. Eine integrierte Hybridschaltung mit einem gesinterten Vielschichtsubstrat (11) mit leitenden Schichten (121, 122, ...), welche auf Oberflächen von Substratschichten (112, 113, ...) des Substrates (11) derart vorgesehen sind, daß jede leitende Schicht (121, 122, ...) zwischen zwei Substratschichten (111, 112, 113, ...) angeordnet ist, wobei die leitenden Schichten (121, 122, ...) miteinander über Durchgänge, welche mit Leitern (141, 142, ...) gefüllt sind, verbunden sind, dadurch gekennzeichnet, daß die Leiter (141, 142, ...) in den Durchgängen einer ersten Substratschicht (111) je mit einer Schicht (211, 212, ...) aus platiertem Kupfer bedeckt sind, auf welcher eine Leiterschicht (151, 152, ...) gebildet ist.

2. Eine integrierte Hybridschaltung nach Anspruch 1, dadurch gekennzeichnet, daß eine Schicht (201, 202, ...) aus leitendem Material zwischen den Leitern (141, 142, ...) und der Schicht (211, 212, ...) aus platiertem Kupfer vorgesehen ist.

3. Eine integrierte Hybridschaltung nach Anspruch 2, dadurch gekennzeichnet, daß die Schicht (201, 202, ...) aus leitendem Material porös ist.

4. Eine integrierte Hybridschaltung nach einem der Ansprüche 2 oder 3, dadurch gekennzeichnet, daß die Schicht (201, 202, ...) aus leitendem Material durch Sintern hergestellt ist.

5. Eine integrierte Hybridschaltung nach Anspruch 1, dadurch gekennzeichnet, daß ein Schaltungsbereich (22, 24, 26) auf dem Substrat (11) gebildet ist und die Leiterschichten (151, 152, ...) als Verbindungsanschlüsse verwendet werden.

6. Eine integrierte Hybridschaltung nach Anspruch 1, dadurch gekennzeichnet, daß das Substrat (11) aus einer Laminerung einer Mehrzahl von Plattensubstraten (111, 112, ...) besteht.

7. Eine integrierte Hybridschaltung nach Anspruch 1, dadurch gekennzeichnet, daß das Substrat (11) ein Laminat einer Mehrzahl von grünen keramischen Platten (ceramic green sheets) ist, welche eine Aluminiumkeramik als den Hauptbestandteil enthalten, wobei die grünen Keramikplatten derart gebildet sind, daß leitende Schichten (121, 122, ...), die durch das leitende Material mit einem höheren Schmelzpunkt als die Sintertemperatur des Substrates (11) gebildet werden, einzeln auf dessen Oberflächen gebildet werden.

8. Eine integrierte Hybridschaltung nach einem der Ansprüche 2 bis 7, dadurch gekennzeichnet, daß das Substrat (11) durch ein einzelnes vielschichtiges Substrat aufgebaut ist, welches durch Laminieren und Sintern einer Mehrzahl von Plattensubstraten (111, 112, ...) erhalten wird, welches eine Aluminiumkeramik als seinen Hauptbestandteil enthält, wobei das Plattensubstrat derart gebildet wird, daß leitende Schichten (121, 122, ...), welche durch das leitende Material mit einem höheren Schmelzpunkt als die Sintertemperatur des Substrates einzeln darauf auf dessen Oberflächen gebildet wird, wobei die leitenden Schichten auf der Oberfläche des Vielschichtsubstrates derart exponiert sind, daß Schichten (201, 202, ...) aus leitendem Material auf der Substratoberfläche gebildet werden.

9. Eine integrierte Hybridschaltung nach einem der Ansprüche 2 bis 8, dadurch gekennzeichnet, daß Schichten (211, 212, ...) aus platiertem Kupfer derart gebildet werden, daß sie die gesamten Schichten (201, 202, ...) aus leitendem Material bedecken.

10. Eine integrierte Hybridschaltung nach einem der Ansprüche 2 bis 9, dadurch gekennzeichnet, daß die Schichten (216, 217, ...) aus platiertem Kupfer so gebildet sind, daß sie Teile der Schichten (205, 206, ...) aus leitendem Material bedecken.

11. Eine integrierte Hybridschaltung nach Anspruch 1, dadurch gekennzeichnet, daß die Schichten (211, 212, ...) aus platiertem Kupfer so gebildet sind, daß deren Filmdicke innerhalb eines Bereiches von 2 bis 4 µm fallen.

12. Eine integrierte Hybridschaltung nach Anspruch 1, dadurch gekennzeichnet, daß die Leiterschichten (151, 152, ...) durch Leiterschichten aus dickem Film ausgebaut sind, auf wenigstens Teilen der Kupfer-platierten Schichten (211, 212, ...), wobei die Dickfilmleiterschichten Muster bilden, welche sich zu Positionen erstrekken, an denen Schaltungselemente verbunden werden.

13. Eine integrierte Hybridschaltung nach Anspruch 1, dadurch gekennzeichnet, daß die Leiterschichten (151, 152, ...) durch Dickfilmleiterschichten aufgebaut sind, welche wenigstens auf Teilen der Schichten (211, 212, ...) aus platiertem Kupfer aufgedruckt sind und in einer Stickstoffatmosphäre gebacken werden.

14. Eine integrierte Hybridschaltung nach Anspruch 1, dadurch gekennzeichnet, daß die Leiterschichten durch Lötschichten (233, 234) aufgebaut sind, welche mit den Schaltungselementen (24, 26) verbunden sind.

15. Eine Vielschichtstruktur für eine integrierte Hybridschaltung mit einer Mehrzahl von Substratschichten (111, 112, ...) mit Durchgängen darin, welche mit Leitern (141, 142, ...), gefüllt sind und leitenden Schichten (121, 122, ...), welche zwischen den Substratschichten (111, 112, ...) gebildet sind, wobei die leitenden Schichten über die Durchgänge miteinander verbunden sind, dadurch gekennzeichnet, daß die Leiter (141, 142, ...) in den Durchgängen einer ersten Substratschicht (111) je mit einer Schicht (211, 212, . . .) aus platiertem Kupfer bedeckt sind.

**Revendications**

1. Circuit intégré hybride comprenant un substrat multicouche fritté (11) avec des couches conductrices (121, 122, . . .) fourni sur les surfaces des couches (112, 113, . . .) du substrat (11) d'une façon telle que chaque couche conductrice (121, 122, . . .) est interposée entre deux couches (111, 112, 113, . . .) du substrat, les couches conductrices (121, 122, . . .) étant interconnectées via des trous de passage remplis de conducteurs (141, 142, . . .), caractérisé en ce que: les conducteurs (141, 142, . . .) dans les trous de passage d'une première couche (111) du substrat sont recouverts chacun d'une couche (211, 212, . . .) de cuivre plaqué sur lequel est formée une couche de conducteur (151, 152, . . .).

2. Circuit intégré hybride selon la revendication 1, caractérisé en ce qu'une couche de matériau conducteur (201, 202, . . .) est fournie entre les conducteurs (141, 142, . . .) et la couche de cuivre plaqué (211, 212, . . .).

3. Circuit intégré hybride selon la revendication 2, caractérisé en ce que la couche de matériau conducteur (201, 202, . . .) est poreuse.

4. Circuit intégré hybride selon l'une des revendications 2 ou 3, caractérisé en ce que la couche de matériau conducteur (201, 202, . . .) est préparée par frittage.

5. Circuit intégré hybride selon la revendication 1, caractérisé en ce qu'une partie de circuit (22, 24, 26) est formée sur le substrat (11) et la couche de conducteur (151, 152, . . .) est utilisée comme bornes de connexion.

6. Circuit intégré hybride selon la revendication 1, caractérisé en ce que le substrat (11) est constitué d'un stratifié d'une multitude de substrats en feuilles (111, 112, . . .).

7. Circuit intégré hybride selon la revendication 1, caractérisé en ce que le substrat (11) est un stratifié d'une multitude de feuilles vertes en céramique qui contiennent une céramique d'alumine comme constituant principal, les feuilles vertes en céramique étant formées de façon que les couches conductrices (121, 122, . . .) constituées par le matériau conducteur ayant le point de fusion supérieur au point de frittage du substrat (11) soient respectivement formées sur ses surfaces.

8. Circuit intégré hybride selon l'une des revendications 2 à 7, caractérisé en ce que le substrat (11) est constitué par un seul substrat à couches multiples obtenu en laminant et frittant une multitude de substrats en feuilles (111, 112, . . .) qui contiennent une céramique d'alumine comme composant principal, le substrat en feuilles étant formé de façon que les couches conductrices (121, 122, . . .) constituées par le matériau conducteur ayant le point de fusion plus élevé que la température de frittage du subtrat soient respectivement formées sur ses surfaces, les couches conductrices étant exposées sur la surface du substrat à couches multiples de façon que les couches de matériau conducteur (201, 202, . . .) soient formées sur la surface du substrat.

9. Circuit intégré hybride selon l'une des revendications 2 ou 8, caractérisé en ce que les couches (211, 212, . . .) de cuivre plaqué sont formées de manière à recouvrir la totalité des couches en matériau conducteur (201, 202, . . .).

10. Circuit intégré hybride selon l'une des revendications 2 ou 9, caractérisé en ce que les couches (216, 217, . . .) de cuivre plaqué sont formées de façon à recouvrir des parties des couches de matériau conducteur (205, 206, . . .).

11. Circuit intégré hybride selon la revendication 1, caractérisé en ce que les couches revêtues de cuivre (211, 212, . . .) sont formées de façon qu'une épaisseur de pellicule de celles-ci tombent dans la gamme comprise entre 2 et 4 μm.

12. Circuit intégré hybride selon la revendication 1, caractérisé en ce que les couches de conducteur (151, 152, . . .) sont constituées par des couches de conducteur à pellicule épaisse formées sur au moins des parties des couches revêtues de cuivre (211, 212, . . .), les couches de conducteur à, pellicule épaisse formant des motifs qui s'étendent jusqu'à des endroits où les éléments du circuit sont connectés.

13. Circuit intégré hybride selon la revendication 1, caractérisé en ce que les couches de conducteur (151, 152, . . .) sont constituées de couches de conducteur à pellicule épaisse imprimées sur au moins des parties des couches (211, 212, . . .) en cuivre plaqué et cuites dans une atmosphère d'azote.

14. Circuit intégré hybride selon la revendication 1, caractérisé en ce que les couches de conducteur sont constituées par des couches de soudure (233, 234) connectées aux éléments du circuit (24, 26).

15. Structure à couches multiples pour circuit intégré hybride comprenant une multitude de couches de substrat (111, 112, . . .) dans lesquelles des trous de passage sont ménagés, remplis de conducteurs (141, 142, . . .), et de couches conductrices (121, 122, . . .) formées entre les couches de substrat (111, 112, . . .), les couches conductrices étant interconnectées via les trous de passage, caractérisée en ce que: les conducteurs (141, 142, . . .) dans les trous de passage d'une première couche de substrat (11) sont recouverts chacun d'une couche (211, 212, . . .) de cuivre plaqué.

F I G. 1

F I G. 2

F I G. 2A

EP 0 249 755 B1

F I G. 3

F I G. 4

F I G. 5A

F I G. 5B

F I G. 6A

F I G. 6B

F I G. 7

F I G. 8

F I G. 9

F I G. 10

F I G. 11

F I G. 12A

F I G. 12B